# EUROPEAN PATENT APPLICATION

(11) **EP 4 818 215 A1**
(43) Date of publication of application: **07.10.2026**
(21) Application number: 24897509.6
(22) Date of filing: 26.11.2024
(51) Int. Cl.: C08F 8/40, B32B 15/08, B32B 27/00, C08C 19/24, C08F 36/06, C08J 5/24, C08K 5/14, C08L 9/00, C09J 7/35, C09J 109/00, H01B 3/28, H05K 1/03

(54) **COMPOSITION FOR INSULATING LAYER OF PRINTED WIRING BOARD**

(30) Priority: 01.12.2023 JP 2023203637; 07.03.2024 JP 2024035351
(71) Applicant: Nippon Soda Co., Ltd., Tokyo 100-7010 (JP)
(72) Inventor: KAWANISHI, Takuya, Ichihara-shi, Chiba 290-0045 (JP); YAMATE, Taiki, Ichihara-shi, Chiba 290-0045 (JP); SAITO, Mizuki, Ichihara-shi, Chiba 290-0045 (JP); SHIBATA, Yasuhisa, Ichihara-shi, Chiba 290-0045 (JP)
(74) Representative: Mewburn Ellis LLP
(86) International application number: PCT/JP2024/041703
(87) International publication number: WO 2025/115824

(57) **Abstract**

An object of the present invention is to provide a composition for use in an insulating layer of a printed wiring board, the composition having a low dielectric constant and a low dielectric loss tangent and having flame retardance. A resin composition for use in an insulating layer of a printed wiring board, the composition containing polybutadiene, wherein a molar ratio of a 1,2-bond structure and a 1,4-bond structure in the polybutadiene is 60:40 to 100:0, and a phosphorus-containing group of formula (III) is bound to one or more carbon atoms in the polybutadiene (in formula (III), * represents a binding position, X¹ and X² each independently represent a single bond or an oxygen atom, and R¹ and R² each independently represent an organic group.).

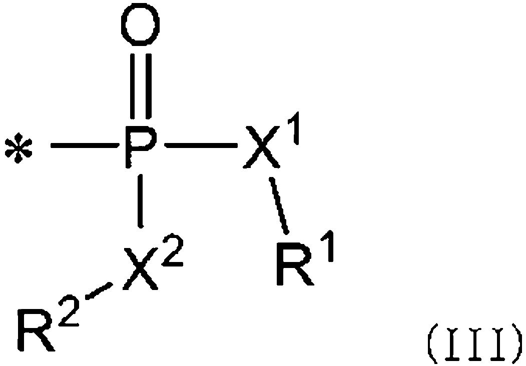

## Description

### Technical Field

The present invention relates to a composition for use in an insulating layer of a printed wiring board.

The present application claims the priorities of Japanese Patent Application No. 2023-203637 filed on December 1, 2023 and Japanese Patent Application No. 2024-035351 filed on March 7, 2024, the contents of which are herein incorporated.

### Background Art

Various known resins are used for producing printed wiring boards and the like included in mobile type communication devices such as cellular phones and smartphones, base station apparatuses therefor, network-related electronic devices such as servers and routers, large computers, and the like.

In recent years, the network-related electronic devices have been required to transmit and process large amounts of information with low losses at high speeds, and electric signals handled in printed wiring boards in products of these devices have also been progressively increased in frequency. Since electric signals at high frequencies are easily attenuated, it is necessary to further reduce the transmission loss in printed wiring boards. Therefore, resins for use in the production of printed wiring boards are demanded to be low in dielectric constant and low in dielectric loss tangent.

In recent years, the regulations on flame-proofing of various industrial products have been severe, and materials for use in printed wiring boards have also been demanded to have flame-proofing.

Patent Document 1 discloses that a phosphoric acid-modified polymer having a phosphorus substituent containing a phosphorus atom directly bound to a carbon atom and also having a double bond has high heat stability.

In the Patent Document, diene-based rubber and the like are exemplified as the polymer, and the Patent Document purports that the phosphorus substituent react with some of double bonds in the polymer to result in addition of a hydrogen atom and a phosphorus atom to such a double bond (hydrophosphonation reaction). The polymer is obtained by allowing a raw material polymer to react with at least one phosphorus compound selected from phosphoric acid, phosphorus acid, and any ester or salt thereof in the presence of a catalyst.

Accordingly, the phosphorus substituent may be bound to any double bond in the polymer, and thus is not bound to only a polymer terminal.

It is disclosed that compounding of the polymer in a rubber composition may allow for expectations of a reduction in heat of generation along with an enhancement in filler dispersion, an enhancement in wet gripping along with an enhancement in hydrophilicity, an enhancement in toughness along with three-dimensional network construction, and an enhancement in wear resistance or the like due to an increase in rate of gelation.

It is only disclosed that the phosphoric acid-modified polymer is used in rubber, and there is no description of electric characteristics thereof or use thereof in insulating layers of printed wiring boards.

### Prior Art Document

### Patent Document

Patent Document 1: WO 2016/063975

### Summary of the Invention

### Object to be Solved by the Invention

An object of the present invention is to provide a composition for use in an insulating layer of a printed wiring board, the composition having a low dielectric constant and a low dielectric loss tangent and having flame retardance.

### Means to Solve the Object

The present inventors have made intensive studies, and as a result, have found that the above problems can be solved by a composition containing a polybutadiene modified with a phosphorus-containing group.

The present invention relates to the following.
(1) A resin composition for use in an insulating layer of a printed wiring board, the composition containing polybutadiene, wherein a molar ratio of a 1,2-bond structure and a 1,4-bond structure in the polybutadiene is 60:40 to 100:0, and a phosphorus-containing group of formula (III) is bound to one or more carbon atoms in the polybutadiene: 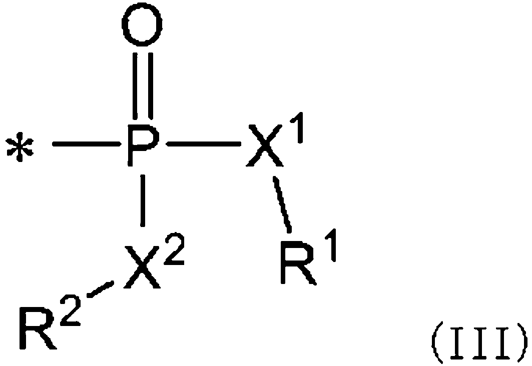 (in formula (III), * represents a binding position, X¹ and X² each independently represent a single bond or an oxygen atom, and R¹ and R² each independently represent an organic group).
(2) The resin composition according to (1), further containing a polymerization initiator.
(3) The resin composition according to (1) or (2), wherein the phosphorus-containing group is bound to only a carbon atom at a terminal in the polybutadiene.
(4) The resin composition according to any one of (1) to (3), wherein a weight average molecular weight of the polybutadiene is 1,000 to 8,000.
(5) The resin composition according to any one of (1) to (4), wherein a molecular weight distribution of the polybutadiene is 1.00 to 3.00.
(6) A prepreg impregnated with the resin composition according to any one of (1) to (5).
(7) An adhesion film having a resin composition layer on a support film, the resin composition layer containing the resin composition according to any one of (1) to (5).
(8) A resin composition-attached metal foil having a resin composition layer on a metal foil, the resin composition layer containing the resin composition according to any one of (1) to (5).
(9) A layered product comprising a layer of a cured product of the resin composition according to any one of (1) to (5), and a metal foil.
(10) A polybutadiene wherein a molar ratio of a 1,2-bond structure and a 1,4-bond structure in the polybutadiene is 60:40 to 100:0, and a phosphorus-containing group of formula (III) is bound to only a carbon atom at a terminal in the polybutadiene: 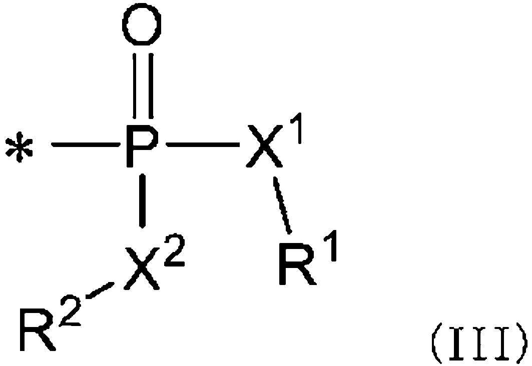 (in formula (III), * represents a binding position, X¹ and X² each independently represent a single bond or an oxygen atom, and R¹ and R² each independently represent an organic group.).
(11) A method for producing the polybutadiene according to (10), the method comprising:
   the step of anionically polymerizing 1,3-butadiene in the presence of a solvent and an anionic initiator, and after the anionically polymerizing step,
   the step of reacting the resultant with a compound of formula (IV): 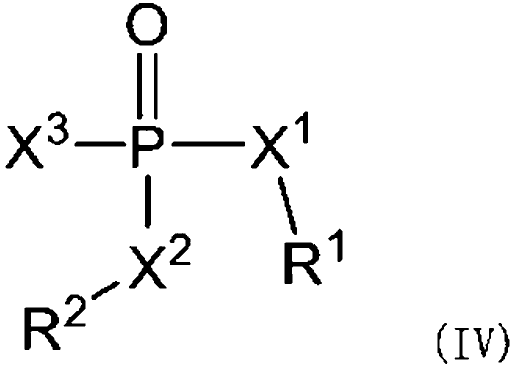 (in formula (IV), X¹, X², R¹ and R² are each defined as in formula (III), X³ represents a halogeno group or a group of formula "-OR³", and R³ represents an organic group).

### Effect of the Invention

The polybutadiene of the present invention has a phosphorus-containing group, and thus a cured product of the polybutadiene of the present invention has flame retardance. In addition, although the polybutadiene of the present invention has a phosphate group, the cured product of the polybutadiene of the present invention has electric characteristics comparable with those of a cured product of an unmodified polybutadiene, and furthermore is excellent in moisture resistance as compared to the cured product of an unmodified polybutadiene.

### Mode of Carrying Out the Invention

The "1,2-bond structure" herein means a repeating unit of formula (I).

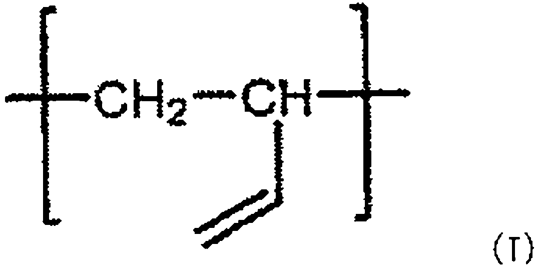

The "1,4-bond structure" herein means a repeating unit of formula (II).

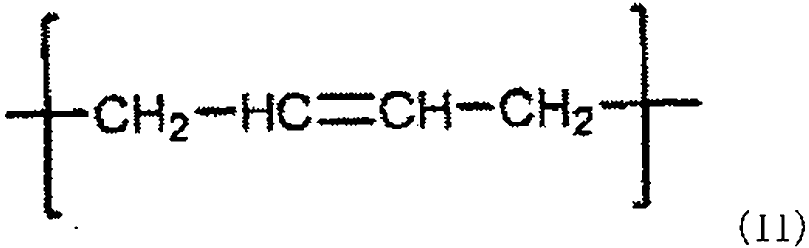

The "terminal" herein may refer to a terminal at one end or terminals at both ends of the polybutadiene.

The "carbon atom at a terminal" herein means a carbon atom of a repeating unit located at a terminal of the polybutadiene.

### <Polybutadiene (hereinafter, sometimes also referred to as "polybutadiene to which a phosphorus-containing group is bound".)>

The polybutadiene of the present invention has only a 1,2-bond structure, or a 1,2-bond structure and a 1,4-bond structure. The molar ratio of the 1,2-bond structure and the 1,4-bond structure in the entire repeating unit in the polybutadiene of the present invention is 60:40 to 100:0, preferably 70:30 to 100:0, and more preferably 70:30 to 95:5. The polybutadiene of the present invention optionally has a repeating unit other than the 1,2-bond structure and the 1,4-bond structure. As the repeating unit other than the 1,2-bond structure and the 1,4-bond structure, a repeating unit in which the 1,2-bond structure is hydrogenated, a repeating unit in which the 1,4-bond structure is hydrogenated, or the like may be exemplified.

The polybutadiene of the present invention has a phosphorus-containing group of formula (III) on one or more carbon atoms in the polybutadiene.

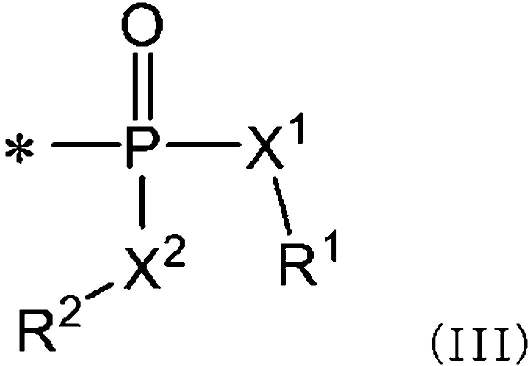

In formula (III), * represents a binding position, X¹ and X² each independently represent a single bond or an oxygen atom, and R¹ and R² each independently represent an organic group.

As the "organic group" in R¹ and R² in formula (III), a C1 to C10 alkyl group, a C2 to C10 alkenyl group, a C2 to C10 alkynyl group, a C6 to C10 aryl group, or the like may be exemplified.

As the C1 to C10 alkyl group, a methyl group, an ethyl group, a n-propyl group, a n-butyl group, a n-pentyl group, a n-hexyl group, a n-heptyl group, a n-octyl group, a n-nonyl group, a n-decyl group, an isopropyl group, a sec-butyl group, an isobutyl group, a tert-butyl group, a neopentyl group, an isopentyl group, a sec-pentyl group, a 1-ethylpropyl group, a tert-pentyl group, an isohexyl group, a 3-methylpentyl group, a 2,2-dimethylbutyl group, a 2,3-dimethylbutyl group, a 1,1,2,2-tetramethylpropyl group, a 1,1,3-trimethylbutyl group, a 1-ethylpentyl group, a 1,1,3,3-tetramethylbutyl group, a 2,2,3,3-tetramethylbutyl group, a 1,2,4-trimethylpentyl group, a 2,4,4-trimethylpentyl group, a 2,2,4-trimethylpentyl group, a 1-ethyl-4-methylpentyl group, a 3-ethyl-3-methylpentyl group, a 3-ethyl-4-methylpentyl group, a 1-ethyl-1-methylpentyl group, a 1,1-dimethylhexyl group, a 3,3-dimethylhexyl group, a 4,4-dimethylhexyl group, a 2-ethylhexyl group, a 3-ethylhexyl group, a 6-methylheptyl group, a 1,3,5-trimethylhexyl group, a 1,1,3-trimethylhexyl group, a 1-methylheptyl group, or the like may be exemplified.

As the C2 to C10 alkenyl group, a vinyl group, a 1-propenyl group, a 2-propenyl group (allyl group), a 1-butenyl group, a 2-butenyl group, a 3-butenyl group, a 1-methyl-2-propenyl group, a 2-methyl-2-propenyl group, or the like may be exemplified.

As the C2 to C10 alkynyl group, an ethynyl group, a 1-propynyl group, a 2-propynyl group, a 1-butynyl group, a 2-butynyl group, a 3-butynyl group, a 1-methyl-2-propynyl group, a 2-methyl-3-butynyl group, a 1-pentynyl group, a 2-pentynyl group, a 3-pentynyl group, a 4-pentynyl group, a 1-methyl-2-butynyl group, a 2-methyl-3-pentynyl group, a 1-hexynyl group, a 1,1-dimethyl-2-butynyl group, or the like may be exemplified.

As the C6 to C10 aryl group, a phenyl group, a naphthyl group, or the like may be exemplified.

R¹ and R² preferably each represent the C1 to C10 alkyl group or the C6 to C10 aryl group.

In the present invention, the polybutadiene to which a phosphorus-containing group is bound is not limited as long as the phosphorus-containing group of formula (III) is bound to one or more carbon atoms in the polybutadiene. The number of carbon atoms to which the phosphorus-containing group is bound is not particularly limited as long as the effects of an insulating layer of a printed wiring board in the present invention are exerted, but, for example, 5 or less, 3 or less, or 2 or less may be exemplified.

The phosphorus-containing group of formula (III) may be located on only a carbon atom at a terminal in the polybutadiene.

The weight average molecular weight (Mw) of the polybutadiene of the present invention is not particularly limited, but, for example, 500 to 8,000, 500 to 6,000, 500 to 5,000, 500 to 4,000, 500 to 3,000, 1,000 to 8,000, 1,000 to 6,000, 1,000 to 5,000, 1,000 to 4,000, or 1,000 to 3,000 may be exemplified.

The molecular weight distribution (weight average molecular weight (Mw)/number average molecular weight (Mn)) of the polybutadiene of the present invention is not particularly limited, but, for example, 1.00 to 3.00 or 1.00 to 2.00 may be exemplified.

The weight average molecular weight and the molecular weight distribution are measured by gel permeation chromatograph (GPC) with polystyrene as a standard substance. The measurement conditions are as follows: a mobile phase THF (tetrahydrofuran), a flow rate of the mobile phase of 1 mL/min, a column temperature of 40°C, an amount of sample injection of 40 µL, and a sample concentration of 2% by weight.

In the present invention, a method for producing the polybutadiene to which a phosphorus-containing group is bound is not particularly limited, but, for example, a method described in WO 2016/063975 may be exemplified. In the case of production by this method, the phosphorus-containing group will be bound to any carbon atom in the polybutadiene.

A method for producing the polybutadiene in which the phosphorus-containing group is bound to only a carbon atom at a terminal is not particularly limited, but, for example, a method including Step 1 of anionically polymerizing 1,3-butadiene in the presence of a solvent and an anionic initiator, and step 2 of allowing a compound of formula (IV) to react after Step 1 may be exemplified. 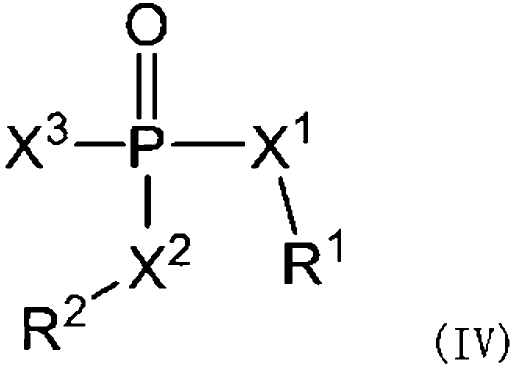 In formula (IV), X¹, X², R¹ and R² are each defined as in formula (III), X³ represents a halogeno group or a group of formula "-OR³", and R³ represents an organic group.

As the halogeno group in X³, a chloro group, a bromo group, an iodo group, or the like may be exemplified.

As the organic group in R³, an organic group that is the same as that exemplified with respect to R¹ and R² may be exemplified.

As the compound of formula (IV), the following compounds may be specifically exemplified: trimethyl phosphate, triethyl phosphate, tripropyl phosphate, triisopropyl phosphate, tributyl phosphate, tri-sec-butyl phosphate, tri-tert-butyl phosphate, tripentyl phosphate, trihexyl phosphate, tris(2-ethylhexyl)phosphate, tris(2-butoxyethyl)phosphate, tricyclohexyl phosphate, tricyclopentyl phosphate, tris(2,2,2-trifluoroethyl) phosphate, tris(1,1,1,3,3,3-hexafluoro-2-propyl) phosphate, tribenzyl phosphate, triallyl phosphate, tris(trimethylsilyl)phosphate, tris(triethylsilyl)phosphate, tris(2-chloroethyl)phosphate, tris(chloropropyl)phosphate, triphenyl phosphate, tricresyl phosphate, cresyl diphenyl phosphate, trixylenyl phosphate, cresyl di-2,6-xylenyl phosphate, 4-hydroxymethyl-2,6,7-trioxa-1-phosphabicyclo[2.2.2]octane1-oxide, 2-(2,2,2-trifluoroethoxy)-1,3,2-dioxaphospholane 2-oxide, dimethyl chlorophosphate, diethyl chlorophosphate, dipropyl chlorophosphate, diisopropyl chlorophosphate, dibutyl chlorophosphate, di-sec-butyl chlorophosphate, di-tert-butyl chlorophosphate, dipentyl chlorophosphate, dihexyl chlorophosphate, bis(2-ethylhexyl)chlorophosphate, bis(2-butoxyethyl)chlorophosphate, dicyclohexyl chlorophosphate, dicyclopentyl chlorophosphate, bis(2,2,2-trifluoroethyl)chlorophosphate, bis(1,1,1,3,3,3-hexafluoro-2-propyl)chlorophosphate, dibenzyl chlorophosphate, diallyl chlorophosphate, bis(trimethylsilyl)chlorophosphate, bis(triethylsilyl)chlorophosphate, bis(2-chloroethyl)chlorophosphate, bis(chloropropyl)chlorophosphate, diphenyl chlorophosphate, dicresyl chlorophosphate, dixylenyl chlorophosphate, 2-chloro-2-oxo-1,3,2-dioxaphospholane, bis(dimethylamino)phosphoryl chloride, chlorodiphenylphosphine oxide, dicyclohexylphosphinyl chloride, chlorodimethylphosphine oxide, chlorodiethylphosphine oxide, chlorodipropylphosphine oxide, chlorodiisopropylphosphine oxide, chloro-di-sec-butylphosphine oxide, chloro-di-tert-butylphosphine oxide and the like.

The solvent is not particularly limited, but, a hydrocarbon-based solvent such as propane, butane, pentane, hexane, heptane, isooctane, cyclopentane, cyclohexane, methylcyclohexane, decane, benzene, or toluene; or an ether-based solvent such as 1,2-dimethoxyethane, 1,2-diethoxyethane, tetrahydrofuran, 2-methoxymethyltetrahydrofuran, diethyl ether, triethylene glycol dimethyl ether, or cyclopentyl methyl ether may be exemplified. As the solvent, a mixed solvent of an ether-based solvent or an ether-based solvent with a hydrocarbon-based solvent is preferably used from the viewpoint of an increase in proportion of the 1,2-bond structure in the polybutadiene.

The anionic polymerization initiator is not particularly limited, but, for example, an organolithium compound such as methyllithium, ethyllithium, propyllithium, n-butyllithium, sec-butyllithium, t-butyllithium, isobutyllithium, hexyllithium, octyllithium, tetramethylenedilithium, pentamethylenedilithium, hexamethylenedilithium, phenyllithium, tolyllithium, or lithium naphthylide; or metallic sodium may be exemplified.

In a case where the phosphorus-containing group is bound to one terminal of the polybutadiene, an organolithium compound is used, and in a case where the phosphorus-containing group is bound to both terminals of the polybutadiene, metallic sodium is used.

The polymerization temperature in step 1 is not particularly limited, but, for example, -78°C to 70°C, - 78°C to 35°C, -78°C to 25°C, -78°C to 10°C, -10°C to 70°C, -10°C to 35°C, -10°C to 25°C, -10°C to 10°C, -5°C to 70°C, -5°C to 35°C, -5°C to 25°C, -5°C to 10°C, or -5°C to 5°C may be exemplified.

### <Resin composition>

The resin composition of the present invention is a resin composition for use in an insulating layer of a printed wiring board. Examples of the printed wiring board include a single-sided printed substrate, a double-sided printed substrate, a multi-layer printed substrate, a flexible printed substrate, and a build-up substrate. The printed wiring board may be produced by a known method with a sheet material described below.

### (Polybutadiene to which phosphorus-containing group is bound)

The resin composition of the present invention contains the polybutadiene to which a phosphorus-containing group is bound.

The content of the polybutadiene to which a phosphorus-containing group is bound, in the resin composition of the present invention, is not particularly limited, but, an amount that is 10 to 95% by weight, 10 to 90% by weight, 20 to 90% by weight, 30 to 90% by weight, 10 to 75% by weight, 20 to 75% by weight, or 30 to 75% by weight with respect to the total weight of the resin composition may be exemplified.

### (Polymerization initiator)

The resin composition of the present invention may further contain a polymerization initiator. As the polymerization initiator used in the resin composition of the present invention, a radical polymerization initiator such as an azo-based initiator or a peroxide-based initiator may be exemplified.

Examples of the azo-based initiator include azobisisobutyronitrile, 1,1'-azobis(cyclohexane-1-carbonitrile), 2,2'-azobis{2-methyl-N-[1,1-bis(hydroxymethyl)ethyl]propionamide}, 2,2'-azobis[2-methyl-N-(2-hydroxyethyl)propionamide], 2,2'-azobis[2-(hydroxymethyl)propionitrile], 2,2'-azobis(2,4-dimethylvaleronitrile), 2,2'-azobis(4-methoxy-2,4-dimethylvaleronitrile), dimethyl 2,2'-azobisisobutyrate, 2,2'-azobis[2-(2-imidazolin-2-yl)propane], and 2,2'-azobis{2-methyl-N-[1,1-bis(hydroxymethyl)-2-hydroxyethyl]propionamide}.

Examples of the peroxide-based initiator include benzoyl peroxide, cumene hydroperoxide, 2,5-dimethylhexane-2,5-dihydroperoxide, α,α'-di(t-butylperoxy)diisopropylbenzene, 2,5-dimethyl-2,5-di(t-butylperoxy)hexyne-3, di-t-butyl peroxide, t-butylcumyl peroxide, α,α'-bis(t-butylperoxy-m-isopropyl)benzene, 2,5-dimethyl-2,5-di(t-butylperoxy)hexane, dicumyl peroxide, dit-butyl peroxyisophthalate, t-butyl peroxybenzoate, 2,2-bis(t-butylperoxy)butane, 2,2-bis(t-butylperoxy)octane, 2,5-dimethyl-2,5-di(benzoylperoxy)hexane, di(trimethylsilyl)peroxide, trimethylsilyltriphenylsilyl peroxide, and diisopropylbenzene hydroperoxide.

The polymerization initiator used in the resin composition of the present invention is preferably a peroxide-based initiator.

The content of the polymerization initiator in the resin composition of the present invention is not particularly limited, but an amount that is 0.1 to 20% by weight, 0.1 to 10% by weight, or 0.1 to 5% by weight with respect to the total weight of the resin composition may be exemplified.

### (Other components)

If necessary, the resin composition of the present invention may contain any other component as long as the effects of the present invention are not impaired. As the other component, a thermosetting resin, an organic solvent, a crosslinking agent, a thermoplastic resin, an inorganic filling agent, an organic filling agent, a flame retardant, any other additive, or the like may be exemplified.

### (Thermosetting resin)

The thermosetting resin is not particularly limited, but, for example, a monomer, a prepolymer, an oligomer or a polymer having a vinyl group, a (meth)acryloyl group, an epoxy group, an oxetanyl group, or a maleimide group may be used. In particular, a polyfunctional resin is preferably used. As specific examples of the thermosetting resin, for example, the following components A-1 to A-5 may be exemplified.

### [Component A-1]

The component A-1 is a maleimide compound. The maleimide compound is not particularly limited as long as it is a compound having one or more maleimide groups in a molecule. As specific examples thereof, for example, N-phenylmaleimide, N-hydroxyphenylmaleimide, bis(4-maleimidephenyl)methane, 2,2-bis{4-(4-maleimidephenoxy)-phenyl}propane, bis(3,5-dimethyl-4-maleimidephenyl)methane, bis(3-ethyl-5-methyl-4-maleimidephenyl)methane, bis(3,5-diethyl-4-maleimidephenyl)methane, polytetramethylene oxide-bis(4-maleimidobenzoate), 2,2-bis[4-(4-maleimidephenoxy)phenyl]propane, 4,4'-diphenylmethane bismaleimide, bis-(3-ethyl-5-methyl-4-maleimidephenyl)methane, 2,2-bis-[4-(4-maleimidephenoxy)phenyl]propane, a maleimide compound of the following formula (IV), a prepolymer of such a maleimide compound, and a prepolymer of a maleimide compound and an amine compound may be exemplified. A commercially available product may be used as the maleimide compound. As the commercially available product, for example, MIR-3000 (manufactured by Nippon Kayaku Co., Ltd.), MIR-3000-70MT (manufactured by Nippon Kayaku Co., Ltd.), BMI (manufactured by K•I Chemical Industry Co., Ltd.), BMI-70 (manufactured by K•I Chemical Industry Co., Ltd.), or BMI-80 (manufactured by K•I Chemical Industry Co., Ltd.) may be exemplified. These may be appropriately used alone or used as a mixture of two or more thereof. 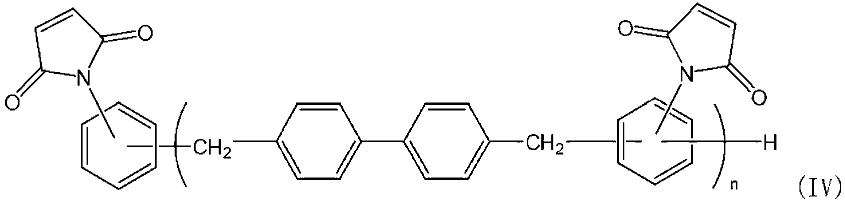 In formula (IV), n represents any integer of 1 to 100. n represents preferably 1 to 50, more preferably 1 to 20, and further preferably 1 to 5.

### [Component A-2]

The component A-2 is a polyphenylene ether compound. The polyphenylene ether compound in the component A-2 is not particularly limited as long as it is a polymer having a repeating unit of the following formula (V). 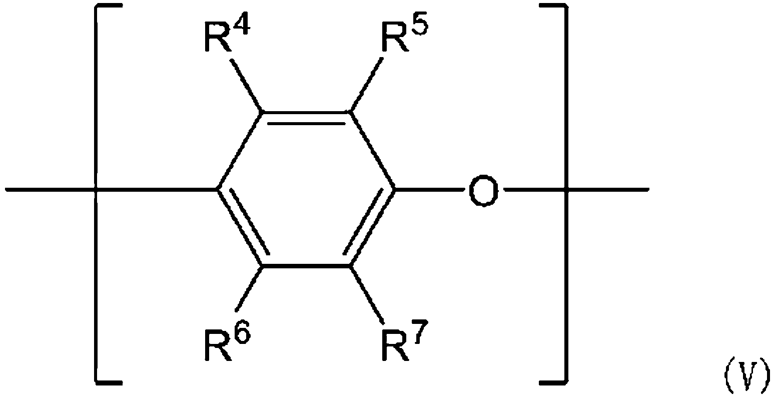 In formula (V), R⁴ to R⁷ each independently represent a hydrogen atom, a C1 to C6 alkyl group, a C2 to C6 alkenyl group, a C2 to C6 alkynyl group, a C1 to C6 alkylcarbonyl group, or C2 to C6 alkenylcarbonyl group.

As the C1 to C6 alkyl group in R⁴ to R⁷, a methyl group, an ethyl group, a n-propyl group, an i-propyl group, a n-butyl group, an i-butyl group, a s-butyl group, a t-butyl group, or the like may be exemplified.

As the C2 to C6 alkenyl group in R⁴ to R⁷, a vinyl group, a 1-propenyl group, a 2-propenyl group (allyl group), a 1-butenyl group, a 2-butenyl group, a 3-butenyl group, a 1-methyl-2-propenyl group, a 2-methyl-2-propenyl group, or the like may be exemplified.

As the C2 to C6 alkynyl group in R⁴ to R⁷, an ethynyl group, a 1-propynyl group, a 2-propynyl group, a 1-butynyl group, a 2-butynyl group, a 3-butynyl group, a 1-methyl-2-propynyl group, a 2-methyl-3-butynyl group, a 1-pentynyl group, a 2-pentynyl group, a 3-pentynyl group, a 4-pentynyl group, a 1-methyl-2-butynyl group, a 2-methyl-3-pentynyl group, a 1-hexynyl group, a 1,1-dimethyl-2-butynyl group, or the like may be exemplified.

As the C1 to C6 alkylcarbonyl group in R⁴ to R⁷, an acetyl group or the like may be exemplified.

As the C2 to C6 alkenylcarbonyl group in R⁴ to R⁷, an acryloyl group, a methacryloyl group, or the like may be exemplified.

A terminal of the polyphenylene ether compound in the component A-2 may be modified. As such a polyphenylene ether compound whose terminal is modified, a polyphenylene ether compound whose terminal is modified with a hydroxyl group, or a polyphenylene ether compound modified with a substituent having a carbon-carbon unsaturated double bond may be exemplified.

As the substituent having a carbon-carbon unsaturated double bond, a group of formula (VI), a group of formula (VII), an acryloyl group or a methacryloyl group may be exemplified. 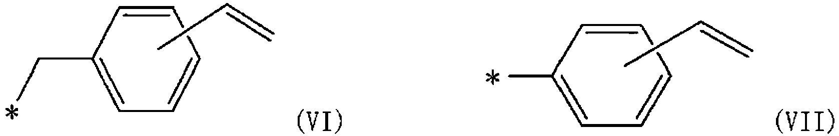 In formula (VI) and formula (VII), * represents a binding position.

Specific examples of the polyphenylene ether compound modified with the substituent having a carbon-carbon unsaturated double bond include a compound of formula (VIII) or formula (IX) . 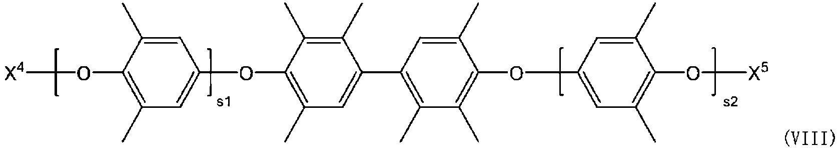 In formula (VIII), X⁴ and X⁵ each independently represent a group of formula (VI), a group of formula (VII), an acryloyl group or a methacryloyl group, and S1 and S2 each independently represent an integer of 0 to 20. The group of formula (VI) and the group of formula (VII) in X⁴ and X⁵ are as described above. 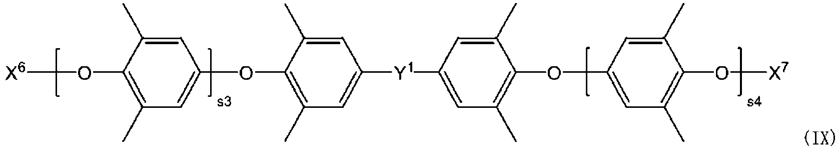 In formula (IX), X⁶ and X⁷ each independently represent a group of formula (VI), a group of formula (VII), an acryloyl group or a methacryloyl group, S3 and S4 each independently represent an integer of 0 to 20, and Y¹ represents a C1 to C6 alkylene group. The group of formula (VI) and the group of formula (VII) in X⁶ and X⁷ are as described above. As the C1 to C6 alkylene group in Y¹, a methylene group, an ethylene group, a methylmethylene group, a dimethylmethylene group, or the like may be exemplified.

The number average molecular weight (Mn) of the polyphenylene ether compound in the component A-2 is not particularly limited, but, 1,000 to 7,000, 1,000 to 5,000, 1,000 to 3,000, or the like may be exemplified. The number average molecular weight (Mn) is a value from the data obtained by gel permeation chromatography (GPC) with tetrahydrofuran as a solvent, in terms of the molecular weight of standard polystyrene.

As the polyphenylene ether compound in the component A-2, known one or a commercially available product may be used. As the commercially available product, for example, SA90 (manufactured by SABIC), SA9000 (manufactured by SABIC), or OPE-2st (manufactured by Mitsubishi Gas Chemical Company, Inc.) may be exemplified. In a case of synthesizing, the polyphenylene ether compound may be synthesized by a method described in WO 2014/203511, for example, or a method based thereon.

In a case where the resin composition of the present invention contains the polyphenylene ether compound being the component A-2, the weight ratio of the polybutadiene and the polyphenylene ether compound may be, for example, 10:90 to 90:10, 20:80 to 90:10, 20:80 to 85:15, 30:70 to 90:10, 30:70 to 85:15, 40:60 to 90:10, or 40:60 to 85:15.

### [Component A-3]

The component A-3 is a polybutadiene in which the molar ratio of a 1,2-bond structure and a 1,4-bond structure is 80:20 to 100:0. The polybutadiene in the component A-3 may be a polybutadiene whose main chain and terminal are unmodified, or may be a polybutadiene whose main chain and terminal are modified (provided that a polybutadiene modified with the phosphorus-containing group is excluded.).

The weight average molecular weight (Mw) of the polybutadiene in the component A-3 is not particularly limited, but, 500 to 10,000, 500 to 8,000, 500 to 6,000, 500 to 5,000, or the like may be exemplified. The weight average molecular weight (Mw) is a value from the data obtained by gel permeation chromatography (GPC) with tetrahydrofuran as a solvent, in terms of the molecular weight of standard polystyrene.

As the polybutadiene in the component A-3, a commercially available product may be used. As the polybutadiene being the commercially available product, NISSO-PB B-1000 (manufactured by Nippon Soda Co., Ltd.), NISSO-PB B-2000 (manufactured by Nippon Soda Co., Ltd.), NISSO-PB B-3000 (manufactured by Nippon Soda Co., Ltd.), or the like may be exemplified. These polybutadienes may be used alone or used by combination of two or more thereof.

### [Component A-4]

The component A-4 is a styrene-butadiene-styrene block copolymer in which the molar ratio of a 1,2-bond structure and a 1,4-bond structure in the butadiene block is 80:20 to 100:0 (hereinafter, sometimes designated as SBS.).

The weight ratio of the styrene block and the butadiene block in SBS in the component A-4 is not particularly limited, but, 10:90 to 80:20, 10:90 to 70:30, 10:90 to 60:40, 20:80 to 80:20, 30:70 to 80:20, or 40:60 to 80:20 may be exemplified.

The weight average molecular weight (Mw) of SBS in the component A-4 is not particularly limited, but, 2,000 to 100,000, 2,000 to 80,000, 2,000 to 60,000, or the like may be exemplified. The molecular weight distribution (Mw/Mn) of SBS is not particularly limited, but, 1.00 to 3.00, 1.00 to 2.00, or the like may be exemplified. The weight average molecular weight (Mw) and the molecular weight distribution (Mw/Mn) are measured by gel permeation chromatograph (GPC) with polystyrene as a standard substance. The measurement conditions are as follows: a mobile phase THF (tetrahydrofuran), a flow rate of the mobile phase of 1 mL/min, a column temperature of 40°C, an amount of sample injection of 40 µL, and a sample concentration of 2% by weight.

A method for producing SBS in the component A-4 is not particularly limited. SBS may be produced by a method described in, for example, Japanese unexamined Patent Application Publication No. H6-192502, Japanese unexamined Patent Application Publication (Translation of PCT Application) No. 2000-514122, Japanese unexamined Patent Application Publication No. 2007-302901, or WO 2021/024679, and a method based thereon.

### [Component A-5]

The component A-5 is a polymer having a repeating unit of formula (1) in a molecule.

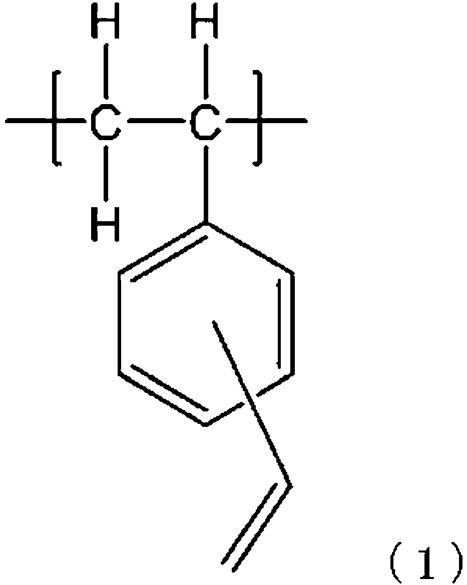

The polymer having a repeating unit of formula (1) in a molecule in the component A-5 may have a repeating unit of formula (2) and/or a repeating unit of formula (3). In a case where the polymer having a repeating unit of formula (1) in a molecule in the component A-5 has a repeating unit of formula (2) and/or a repeating unit of formula (3), the polymer having a repeating unit of formula (1) in a molecule may be a block copolymer or a random copolymer.

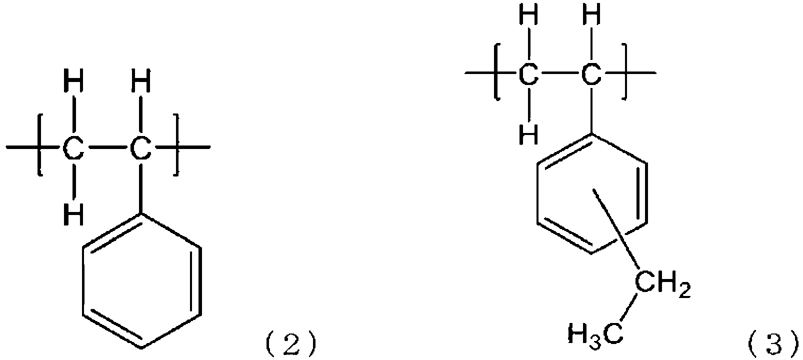

The weight average molecular weight of the polymer having a repeating unit of formula (1) in a molecule in the component A-5 is preferably 1,200 to 40,000, and more preferably 1,200 to 35,000. The weight average molecular weight (Mw) is a value from the data obtained by gel permeation chromatography (GPC) with tetrahydrofuran as a solvent, in terms of the molecular weight of standard polystyrene.

As the polymer having a structural unit of formula (1) in a molecule in the component A-5, a commercially available product may be used. As the commercially available product, ODV-XET-X03 (manufactured by NIPPON STEEL Chemical & Material Co., Ltd.), ODV-XET-X04 (manufactured by NIPPON STEEL Chemical & Material Co., Ltd.), ODV-XET-X05 (manufactured by NIPPON STEEL Chemical & Material Co., Ltd.), or the like may be exemplified.

### (Organic solvent)

The organic solvent is not particularly limited, but, an amide-based, ether-based, ester-based, aliphatic hydrocarbon-based, aromatic hydrocarbon-based, ketone-based, or organohalogen compound-based solvent, or the like may be exemplified.

As the amide-based organic solvent, N,N-dimethylformamide (DMF), N,N-dimethylacetamide, or the like may be exemplified; as the ether-based organic solvent, diethyl ether, dipropyl ether, dibutyl ether, diamyl ether, tetrahydrofuran, or the like may be exemplified; as the ester-based organic solvent, ethyl acetate, propyl acetate, butyl acetate, amyl acetate, heptyl acetate, ethyl butyrate, isoamyl isovalerate, propylene glycol methyl ether acetate, or the like may be exemplified; as the aliphatic hydrocarbon-based organic solvent, n-hexane, n-heptane, cyclohexane, or the like may be exemplified; as the aromatic hydrocarbon-based organic solvent, toluene, xylene, or the like may be exemplified; as the ketone-based organic solvent, methyl ethyl ketone, methyl isobutyl ketone, cyclohexanone, or the like may be exemplified; and, as the organohalogenated product-based organic solvent, trichloroethane, trichloroethylene, or the like may be exemplified. Furthermore, a relatively inactive organic solvent such as propylene glycol monomethyl ether or propylene glycol monoethyl ether may also be used.

### (Crosslinking agent)

The crosslinking agent is not particularly limited, but, for example, a polyfunctional vinyl compound such as divinylbenzene, divinylnaphthalene, or divinylbiphenyl; a vinyl benzyl ether-based compound synthesized from a reaction of phenol and vinyl benzyl chloride; a styrene monomer; an allyl ether-based compound synthesized from a reaction of phenol and allyl chloride; a trialkenyl isocyanurate such as triallyl isocyanurate (TAIC (registered trademark)) or triallyl cyanurate (TAC); a (meth)acrylate compound (methacrylate compound and acrylate compound) such as trimethylolpropane; or a compound having an acenaphthylene backbone may be exemplified. When such a crosslinking agent is used, heat resistance may be enhanced. These crosslinking agents may be used alone or used by combination of two or more thereof.

As the compound having an acenaphthylene backbone, acenaphthylene; a hydroxyacenaphthylene compound such as 3-hydroxyacenaphthylene, 4-hydroxyacenaphthylene, 5-hydroxyacenaphthylene, or 5,6-dihydroxyacenaphthylene; an alkylacenaphthylene compound such as 3-methylacenaphthylene, 3-ethylacenaphthylene, 3-propylacenaphthylene, 4-methylacenaphthylene, 4-ethylacenaphthylene, 4-propylacenaphthylene, 5-methylacenaphthylene, 5-ethylacenaphthylene, 5-propylacenaphthylene, 3,8-dimethylacenaphthylene, or 5,6-dimethylacenaphthylene; an alkoxyacenaphthylene compound such as 3-methoxyacenaphthylene, 3-ethoxyacenaphthylene, 3-butoxyacenaphthylene, 4-methoxyacenaphthylene, 4-ethoxyacenaphthylene, 4-butoxyacenaphthylene, 5-methoxyacenaphthylene, 5-ethoxyacenaphthylene, or 5-butoxyacenaphthylene; a halogenated acenaphthylene compound such as 3-chloroacenaphthylene, 3-bromoacenaphthylene, 4-chloroacenaphthylene, 4-bromoacenaphthylene, 5-chloroacenaphthylene, or 5-bromoacenaphthylene; or the like may be exemplified.

### (Thermoplastic resin)

The thermoplastic resin is not particularly limited, but, for example, a polyacrylate resin, a polymethacrylate resin, a polystyrene resin, a polyphenylene ether resin, a polyetherimide resin, a polyethersulfone resin, a polyphenylene sulfide resin, a polycyclopentadiene resin, a polycycloolefin resin, a polycycloolefin copolymer resin, a polyarylate resin, a polyether resin, a phenoxy resin, a polyvinyl acetal resin, a polyolefin resin, a polybutadiene resin, a polyimide resin, a polyamideimide resin, a polyetherimide resin, a polysulfone resin, a polyethersulfone resin, a polycarbonate resin, a polyetheretherketone resin, a polyester resin, a liquid crystal polyester resin, or a fluororesin; a known thermoplastic elastomer, for example, a styrene-ethylene-propylene copolymer, a styrene-ethylene-butylene copolymer, a styrene-butadiene copolymer, a styrene-isoprene copolymer, a hydrogenated styrene-butadiene copolymer, a hydrogenated styrene-isoprene copolymer, a (meth)acrylonitrile-butadiene-(meth)acrylic acid copolymer, a (meth)acrylonitrile-butadiene-methyl(meth)acrylate copolymer, a methyl(meth)acrylate-butadiene-styrene copolymer (MBS), or (meth)acrylonitrile-butadiene rubber (NBR), linear polyurethane, polybutadiene, polyisoprene, fluorine-based rubber, or ethylene-propylene-diene rubber may be exemplified.

### (Inorganic filling material)

The material of the inorganic filling material is not particularly limited, but, for example, silica, alumina, glass, cordierite, silicon oxide, barium sulfate, barium carbonate, talc, clay, mica powder, zinc oxide, hydrotalcite, boehmite, aluminum hydroxide, magnesium hydroxide, calcium carbonate, magnesium carbonate, magnesium oxide, boron nitride, aluminum nitride, manganese nitride, aluminum borate, strontium carbonate, strontium titanate, calcium titanate, magnesium titanate, bismuth titanate, titanium oxide, zirconium oxide, barium titanate, barium zirconate titanate, barium zirconate, calcium zirconate, zirconium phosphate, or zirconium tungstate phosphate may be exemplified. Among these, silica is particularly suitable. The silica is preferably spherical silica. These inorganic filling materials may be used alone or used by combination of two or more thereof.

The inorganic filling material is preferably treated with one or more surface treatment agents such as an aminosilane-based coupling agent, an epoxysilane-based coupling agent, a mercaptosilane-based coupling agent, a silane-based coupling agent, an organosilazane compound, a titanate-based coupling agent, a vinylsilane-based coupling agent, a methacryloxysilane-based coupling agent, an acryloxysilane-based coupling agent, and a styrylsilane-based coupling agent.

### (Organic filling material)

The organic filling material is not particularly limited, but, for example, a rubber particle, a fluororesin particle (fluoropolymer particle), a polyamide fine particle, or a silicone particle may be exemplified.

As the rubber particle, a commercially available product may also be used, and, for example, "EXL-2655" manufactured by Dow Chemical Japan Ltd., or "AC3816N" manufactured by Aica Kogyo Co., Ltd. may be exemplified.

As the fluororesin particle (fluoropolymer particle), for example, polytetrafluoroethylene (PTFE), perfluoroalkoxyalkane (PFA), a perfluoroethylene-propene copolymer (FEP), an ethylene-tetrafluoroethylene copolymer (ETFE), a tetrafluoroethylene-perfluorodioxole copolymer (TFE/PDD), polyvinylidene fluoride (PVDF), polychlorotrifluoroethylene (PCTFE), an ethylene-chlorotrifluoroethylene copolymer (ECTFE), or polyvinyl fluoride (PVF) may be exemplified. These resins may be used alone or used by combination of two or more thereof.

As the fluororesin particle (fluoropolymer particle), a commercially available product may also be used, and, for example, "Lubron (registered trademark) L-2" manufactured by Daikin Industries, Ltd., "Lubron L-5" manufactured by Daikin Industries, Ltd., "Lubron L-5F" manufactured by Daikin Industries, Ltd., "Fluon (registered trademark) PTFE L-170JE" manufactured by Asahi Glass Co., Ltd., "Fluon PTFE L-172JE" manufactured by Asahi Glass Co., Ltd., "Fluon PTFE L-173JE" manufactured by Asahi Glass Co., Ltd., "KTL-500F" manufactured by KITAMURA LIMITED, "KTL-2N" manufactured by KITAMURA LIMITED, "KTL-1N" manufactured by KITAMURA LIMITED, or "TLP10F-1" manufactured by Mitsui Dupont Fluorochemicals Co., Ltd. may be exemplified.

The inorganic filling agent and the organic filling material may each contain a surface-treated particle. Examples of the surface treatment include a surface treatment with a surface treatment agent. The surface treatment agent is not particularly limited. The surface treatment agent includes not only a surfactant such as a nonionic surfactant, an ampholytic surfactant, a cationic surfactant, or an anionic surfactant, but also an inorganic fine particle. As the surface treatment agent, a fluorine-based surfactant is preferably used from the viewpoint of affinity. Specific examples of the fluorine-based surfactant include "Surflon (registered trademark) S-243" (perfluoroalkyl ethylene oxide adduct) manufactured by AGC Seimi Chemical Co., Ltd., "Megaface (registered trademark) F-251" manufactured by DIC Corporation, "Megaface F-477" manufactured by DIC Corporation, "Megaface F-553" manufactured by DIC Corporation, "Megaface R-40" manufactured by DIC Corporation, "Megaface R-43" manufactured by DIC Corporation, "Megaface R-94" manufactured by DIC Corporation, "FTX-218" manufactured by NEOS Co., Ltd., "Ftergent (registered trademark) 610FM" manufactured by NEOS Co., Ltd., and "Ftergent 730LM" manufactured by NEOS Co., Ltd.

### (Flame retardant)

The flame retardant is not particularly limited, but, for example, a halogen-based flame retardant, or a phosphorus-based flame retardant may be exemplified.

As the halogen-based flame retardant, for example, ethylenedipentabromobenzene, ethylenebistetrabromoimide, decabromodiphenyl oxide, or tetradecabromodiphenoxybenzene that has a melting point of 300°C or more may be exemplified.

As the phosphorus-based flame retardant, a phosphate-based flame retardant such as condensed phosphate of dixylenyl phosphate, a phosphazene-based flame retardant such as phenoxyphosphazene, a phosphinate-based flame retardant such as a metal salt of phosphinic acid, such as aluminum dialkyl phosphinate, or the like may be exemplified.

Each of the flame retardants exemplified may be used alone or used by combination of two or more thereof.

### (Other additives)

Examples of other additives include a defoaming agent such as a silicone-based defoaming agent or an acrylate-based defoaming agent, an organometallic compound such as an organocopper compound, an organozinc compound or an organocobalt compound, a leveling agent, an adhesion aid such as a silane coupling agent, a tackifying agent such as a tackifier, a heat stabilizer, an antistatic agent, a storage stabilizer such as BHT, an antioxidant, a light stabilizer, an ultraviolet absorber, a dye and a pigment, a lubricant, a wet dispersant, a heavy metal deactivator, an ion trapping agent, an emulsifier, a water dispersion stabilizer, a release agent, wax, a rheology control agent, and a surfactant.

### (Varnish)

When a sheet-shaped layering material described below is produced, the resin composition of the present invention may be formed into a varnish, to provide a resin varnish.

The resin varnish is prepared as follows, for example.

Each component is added and dissolved in the organic solvent. Here, the resulting solution may be heated, if necessary. If necessary, a component insoluble in the organic solvent, such as an inorganic filling material, is then added, and dispersed with a ball mill, a bead mill, a planetary mixer, a roll mill, or the like, to prepare the resin varnish.

### <Sheet-shaped layering material>

The resin composition of the present invention may be used in a sheet-shaped layering material. Examples of the sheet-shaped layering material include a prepreg, an adhesion film, and a thermosetting resin composition-attached metal foil described below.

### <Prepreg>

The prepreg of the present invention is characterized in that a base material is impregnated with the resin composition of the present invention.

Examples of the base material include a fibrous base material such as a glass cloth, an aramid cloth, a polyester cloth, a glass non-woven cloth, an aramid non-woven cloth, a polyester non-woven cloth, pulp paper, or linter paper. The thickness of the base material is not particularly limited, but is preferably 20 to 800 µm, and more preferably 20 to 300 µm.

The prepreg of the present invention may be produced by a known method. A method including impregnating the base material with the resin composition of the present invention, and then drying the resultant may be exemplified.

A prepreg in a semi-cured state (B stage) may be obtained by heating the base material impregnated with the resin composition in desired heating conditions, for example, at 80 to 170°C for 1 to 10 minutes to remove the solvent.

### <Adhesion film>

The adhesion film of the present invention is characterized by having a resin composition layer containing the resin composition of the present invention on a support film. The adhesion film of the present invention may be produced by a known method. For example, the resin composition of the present invention may be applied to the support film using a die coater or the like, followed by vaporizing the organic solvent by, for example, heating or blowing of hot air, to form the resin composition layer.

The drying conditions are not particularly limited, but the drying is performed such that the content of the organic solvent in the resin composition layer is 10% by weight or less, and preferably 5% by weight or less. The drying conditions vary depending on the amount of the organic solvent in the resin composition and the boiling point of the organic solvent, and a resin composition layer containing the resin composition of the present invention may be formed by, for example, drying the resin composition containing 30 to 60% by weight of the organic solvent at 50 to 150°C for about 3 to 10 minutes.

The thickness of the resin composition layer formed in the adhesion film is not particularly limited, but is preferably 5 to 200 µm. The thickness is more preferably 15 to 80 µm from the viewpoint of film thinning.

Examples of the support film include various plastic films such as a film of a polyolefin such as polyethylene, polypropylene, or polyvinyl chloride; a film of a polyester such as polyethylene terephthalate (hereinafter, sometimes abbreviated as "PET".) or polyethylene naphthalate; a polycarbonate film; and a polyimide film. Alternatively, release paper, or a metal foil such as a copper foil or an aluminum foil may also be used. In particular, a plastic film is preferable, and a polyethylene terephthalate film is more preferable from the viewpoint of general-purpose properties. A support and a protection film described below may be each subjected to a surface treatment such as a mud treatment or a corona treatment. Such support and protection film may also be each subjected to a release treatment with a release agent such as a silicone resin-based release agent, an alkyd resin-based release agent, or a fluororesin-based release agent.

The thickness of the support film is not particularly limited, but is preferably 10 to 150 µm, and more preferably 25 to 50 µm.

A protection film according to the support may be further layered on a surface of the resin composition layer to which no support adheres. The thickness of the protection film is not particularly limited, but is, for example, 1 to 40 µm. Layering the protection film may prevent attachment of dust or the like to or scratching on the surface of the resin composition layer. The adhesion film may also be wound on a roll and then stored.

### <Resin composition-attached metal foil>

The resin composition-attached metal foil of the present invention is characterized by having a resin composition layer containing the resin composition of the present invention on a metal foil. Examples of the metal foil used here include a copper foil and an aluminum foil. The thickness is not particularly limited, but is preferably in the range of 3 to 200 µm, and more preferably in the range of 5 to 105 µm.

A method for producing the resin composition-attached metal foil of the present invention is not particularly limited, and examples thereof include a method including uniformly dissolving or dispersing the resin composition in an aromatic solvent, ketone-based solvent, or the like, or a mixed solvent thereof, coating a metal foil with the resulting solution or dispersion, and then drying the resultant. If necessary, such coating may be repeated plural times, or a plurality of solutions different in formulation and concentration may also be used to repeat the coating, thereby finally achieve the desired resin formulation and the resin amount.

The thickness of the resin composition layer formed in the resin composition-attached metal foil of the present invention is not particularly limited, but is preferably 5 to 200 µm.

The resin composition-attached metal foil of the present invention may also be provided with a release film on a surface of a layer of the resin composition to which no metal foil adheres. As the release film, for example, a resin film mainly containing a polyolefin such as polyethylene or polypropylene; a polyester such as polyethylene terephthalate, or polyethylene naphthalate; a polyimide; or a polycarbonate may be used. A surface thereof may also be coated with a silicone resin release agent or the like to adjust the release intensity.

The thickness of the release film is preferably 1 to 300 µm, more preferably 5 to 200 µm, further preferably 10 to 150 µm, and still further preferably 20 to 120 µm.

A surface of the release film, with which a resin sheet is contacted, may be subjected to a mat treatment, a corona treatment, or an antistatic treatment.

### <Layered product>

The metal foil-attached, layered product of the present invention includes a layer of the resin composition of the present invention, and a metal foil. Examples of the metal foil used here include a copper foil and an aluminum foil. The thickness is not particularly limited, but is in the range of 3 to 200 µm, more preferably 5 to 105 µm.

A method for producing the layered product of the present invention is not particularly limited, but, for example, a method including layering the above-described sheet-shaped layering material of the present invention and the metal foil according to the intended layer configuration, and allowing these layers to simultaneously adhere and thermally cure under heating and pressure may be exemplified. In the metal foil-attached, layered product of the present invention, a layer of the thermosetting resin in the present invention, and the metal foil are layered according to any layer configuration. The metal foil may be used as a surface layer or an intermediate layer. Besides the above, multi-layering may also be achieved by repeating layering and curing plural times.

Hereinafter, Examples of the present invention are given, but the technical scope of the present invention is not limited to these Examples.

### Examples

### <Weight average molecular weight (Mw) and dispersibility (Mw/Mn)>

The weight average molecular weight of each polymer obtained in Examples was measured with the following apparatuses and conditions.

### [Apparatuses]

Sample injection apparatus: Waters 2695 Alliance
Separation column: Shodex KF-G, 803, 802, 801
Detector: Waters 2414 differential refraction (RI) detector 2998 photodiode array (PDA) detector
Column oven: column oven manufactured by Waters Corporation

### [Conditions]

Column oven temperature: 40°C
RI detector temperature: 40°C
Mobile phase: tetrahydrofuran
Flow rate: 1.0 mL/min
Standard amount of injection: 40 µL
Wave extracted by PDA detector: 254.0 nm
Quantitative calculation: standard polystyrene conversion

### (Example 1) Method for producing polybutadiene A

To a reaction container were added 607 g of cyclopentyl methyl ether and 44 g of n-butyllithium (hexane solution having a concentration of 14.7% by weight). The inner temperature of the reaction container was set to 0°C, 100 g of 1,3-butadiene was dropped and stirred for 30 minutes, to obtain a polymerization liquid. The polymerization liquid was dropped into a triphenyl phosphate solution in cyclopentyl methyl ether (the amount of triphenyl phosphate in the solution was 67 g.) at room temperature and stirred for 20 minutes, to obtain a reaction liquid. To the reaction liquid was added 400 g of 3% acetic acid in water, and liquid separation was performed. After the resulting organic layer was washed with water twice, the solvent was distilled off by an evaporator until the solid content in the organic layer reached 50%. The organic layer was dropped into 4 L of methanol to precipitate a polymer, followed by subjecting the supernatant to decantation. The polymer was dried in an oven, thereby obtaining polybutadiene A.

Polybutadiene A obtained was analyzed by gel permeation chromatography (mobile phase THF, polystyrene standard), and thus was confirmed to have a weight average molecular weight (Mw) of 1,700 and a molecular weight distribution (Mw/Mn) of 1.13. Polybutadiene A had 78% by mol of a 1,2-bond structure, as calculated by ¹H-NMR. It was confirmed by ICP-OES (inductively coupled plasma optical emission spectroscopy) that a triphenyl phosphate-derived phosphorus-containing group was bound to the polybutadiene. It was presumed in consideration of the production method that the phosphorus-containing group was bound to one terminal of the polybutadiene.

### (Example 2) Method for producing polybutadiene B

Polybutadiene B was produced in the same manner as in Example 1 except that triphenyl phosphate was changed to tributyl phosphate.

Polybutadiene B was analyzed by gel permeation chromatography (mobile phase THF, polystyrene standard), and thus was confirmed to have a weight average molecular weight (Mw) of 1,700 and a molecular weight distribution (Mw/Mn) of 1.13. The polybutadiene had 78% by mol of a 1,2-bond structure, as calculated by ¹H-NMR. It was confirmed by ICP-OES that a tributyl phosphate-derived phosphorus-containing group was bound to the polybutadiene. It was presumed in consideration of the production method that the phosphorus-containing group was bound to one terminal of the polybutadiene.

### (Example 3) Method for producing polybutadiene C

Polybutadiene C was produced in the same manner as in Example 1 except that triphenyl phosphate was changed to chlorodiphenylphosphine oxide.

Polybutadiene C was analyzed by gel permeation chromatography (mobile phase THF, polystyrene standard), and thus was confirmed to have a weight average molecular weight (Mw) of 1,100 and a molecular weight distribution (Mw/Mn) of 1.26. The polybutadiene had 78% by mol of a 1,2-bond structure, as calculated by ¹H-NMR. It was confirmed by ICP-OES that a chlorodiphenylphosphine oxide-derived phosphorus-containing group was bound to the polybutadiene. It was presumed in consideration of the production method that the phosphorus-containing group was bound to one terminal of the polybutadiene.

### (Example 4) Method for producing polybutadiene D

Polybutadiene D was produced in the same manner as in Example 1 except that triphenyl phosphate was changed to tris(2-ethylhexyl)phosphate.

Polybutadiene D was analyzed by gel permeation chromatography (mobile phase THF, polystyrene standard), and thus was confirmed to have a weight average molecular weight (Mw) of 2,000 and a molecular weight distribution (Mw/Mn) of 1.09. The polybutadiene had 76% by mol of a 1,2-bond structure, as calculated by 1H-NMR. It was confirmed by ICP-OES that a tris(2-ethylhexyl)phosphate-derived phosphorus-containing group was bound to the polybutadiene. It was presumed in consideration of the production method that the phosphorus-containing group was bound to one terminal of the polybutadiene.

### (Example 5) Method for producing polybutadiene E

Polybutadiene E was produced in the same manner as in Example 1 except that triphenyl phosphate was changed to tricresyl phosphate.

Polybutadiene E was analyzed by gel permeation chromatography (mobile phase THF, polystyrene standard), and thus was confirmed to have a weight average molecular weight (Mw) of 2,300 and a molecular weight distribution (Mw/Mn) of 1.21. The polybutadiene had 77% by mol of a 1,2-bond structure, as calculated by 1H-NMR. It was confirmed by ICP-OES that a tricresyl phosphate-derived phosphorus-containing group was bound to the polybutadiene. It was presumed in consideration of the production method that the phosphorus-containing group was bound to one terminal of the polybutadiene.

### (Example 6) Method for producing cured product

Reagents were mixed according to the formulation (parts by weight) in Tables 1 to 3. A resin composition was cured by heat pressing at 200°C for 120 minutes, thereby obtaining a cured product.

**[Table 1]**

| | Cured product 1 | Cured product 2 | Cured product 3 | Reference cured product 1 |
|---|---|---|---|---|
| Polybutadiene A | 100 | | | |
| Polybutadiene B | | 100 | | |
| Polybutadiene C | | | 100 | |
| B-3000 | | | | 100 |
| Percumyl D | 16 | 16 | 16 | 2 |

| | | | | |
|---|---|---|---|---|
| • B-3000: liquid polybutadiene manufactured by Nippon Soda Co., Ltd. • Percumyl D: dicumyl peroxide manufactured by NOF Corporation | | | | |

**[Table 2]**

| | Cured product 4 | Cured product 5 | Reference cured product 2 | Reference cured product 3 |
|---|---|---|---|---|
| SA9000 | 60 | 15 | 92 | 100 |
| Polybutadiene A | 40 | 85 | | |
| DOPO | | | 8 | |
| Percumyl D | 2 | 16 | 2 | 2 |

| | | | | |
|---|---|---|---|---|
| • SA9000: methacryl-modified polyphenylene ether compound manufactured by SABIC Innovative Plastics • DOPO: 9,10-dihydro-9-oxa-10-phosphaphenanthrene 10-oxide manufactured by Tokyo Chemical Industry Co., Ltd. • Percumyl D: dicumyl peroxide manufactured by NOF Corporation | | | | |

**[Table 3]**

| | Cured product 6 | Cured product 7 | Cured product 8 |
|---|---|---|---|
| SA9000 | 60 | 60 | 60 |
| Polybutadiene C | 40 | | |
| Polybutadiene D | | 40 | |
| Polybutadiene E | | | 40 |
| Percumyl D | 2 | 2 | 2 |

| | | | |
|---|---|---|---|
| • SA9000: methacryl-modified polyphenylene ether compound manufactured by SABIC Innovative Plastics • Percumyl D: dicumyl peroxide manufactured by NOF Corporation | | | |

### (Example 7) Method for producing varnish

Reagents were blended according to the formulation (parts by weight) in Table 4, and the resultant was stirred and mixed with a mixed solvent of methyl ethyl ketone and cyclohexanone to homogenize, thereby preparing a varnish of a resin composition.

**[Table 4]**

| | Cured product 9 | Reference cured product 4 | Reference cured product 5 | Reference cured product 6 |
|---|---|---|---|---|
| SA9000 | 60 | 60 | 60 | 60 |
| B-1000 | | 40 | 40 | 40 |
| Polybutadiene C | 40 | | | |
| DOPO | 10.5 | 15 | 11.7 | |
| Percumyl D | 2 | 16 | 2 | 2 |
| SC2300-SVJ | 60 | 60 | 60 | 60 |
| P content | 2.0 | 2.0 | 1.5 | 0 |

| | | | | |
|---|---|---|---|---|
| • SA9000: methacryl-modified polyphenylene ether compound manufactured by SABIC Innovative Plastics • B-1000: liquid polybutadiene manufactured by Nippon Soda Co., Ltd. • DOPO: 9,10-dihydro-9-oxa-10-phosphaphenanthrene 10-oxide manufactured by Tokyo Chemical Industry Co., Ltd. • Percumyl D: dicumyl peroxide manufactured by NOF Corporation • SC2300-SVJ: silica filler manufactured by Admatechs | | | | |

### (Example 8) Method for producing prepreg

A glass cloth (manufactured by Nitto Boseki Co., Ltd., #2116 type, WEA116, E glass, thickness 0.1 mm) was impregnated with the above varnish, and thereafter the resultant was heated and dried at 100°C for 15 minutes, thereby producing a prepreg.

### (Example 9) Method for producing flame-retardance test piece

Ten of the above prepregs were stacked, and cured by heat pressing at 200°C for 120 minutes, thereby obtaining a cured product. A test piece having a length of 125 mm and a width of 13 mm was cut out from the cured product, thereby producing a flame-retardance test piece.

### (Test Examples 1 to 6, Reference Example 1 and Reference Example 2)

The cured product obtained in Example 6 was subjected to measurement for the following items. The results are shown in Tables 5 and 6.

### <Relative dielectric constant (Dk) and dielectric loss tangent (Df)>

Measurement was performed at 10 GHz with a cylindrical cavity resonator (TE mode resonator) manufactured by AET, Inc.

### <Dielectric loss tangent (Df) after moisture absorption>

The cured product used in the above dielectric loss tangent measurement was treated under conditions of a temperature of 85°C and a relative humidity of 85% for 72 hours. After the moisture absorption treatment, the water and moisture on the cured product was wiped off with a dry and clean cloth. The dielectric loss tangent (dielectric loss tangent after water absorption) of the cured product subjected to the moisture absorption treatment was measured by the same method as in the measurement of the dielectric loss tangent before the above water absorption treatment.

**[Table 5]**

| | Test Example 1 | Test Example 2 | Test Example 3 | Reference Example 1 | Reference Example 2 |
|---|---|---|---|---|---|
| Cured product | Cured product 1 | Cured product 4 | Cured product 5 | Reference cured product 1 | Reference cured product 3 |
| Relative dielectric constant (Dk) | 2.43 | 2.27 | 2.23 | 2.21 | 2.61 |
| Dielectric loss tangent (Df) | 0.0021 | 0.0033 | 0.0042 | 0.0022 | 0.0054 |
| Dielectric loss tangent (Df) after moisture absorption | 0.0029 | 0.0038 | 0.0057 | 0.0062 | 0.0072 |

**[Table 6]**

| | Test Example 4 | Test Example 5 | Test Example 6 |
|---|---|---|---|
| Cured product | Cured product 6 | Cured product 7 | Cured product 8 |
| Relative dielectric constant (Dk) | 2.62 | 2.53 | 2.37 |
| Dielectric loss tangent (Df) | 0.0036 | 0.0036 | 0.0028 |
| Dielectric loss tangent (Df) after moisture absorption | 0.0051 | 0.0059 | 0.0028 |

According to Test Example 1, it can be seen that a cured product (cured product 1) of polybutadiene A has electric characteristics comparable with those of a cured product (reference cured product 1) of B-3000, which has been known to have excellent electric characteristics. It can also be seen that cured product 1 is excellent in dielectric loss tangent after moisture absorption as compared to reference cured product 1 and thus cured product 1 is excellent in moisture absorption resistance.

According to Test Examples 2 to 6, it can be seen that cured products (cured product 4 to cured product 8) of polybutadiene A and SA9000 are excellent in electric characteristics and moisture absorption resistance as compared to a cured product (reference cured product 3) of SA9000.

### (Test Example 7 and Reference Examples 3 to 5) Flame retardance test

A test piece was produced according to the flame retardance UL94 standard, and a flame retardance test was performed. Determination criteria were in accordance with UL94 standard. The results are shown in Table 7.

**[Table 7]**

| | Test Example 7 | Reference Example 3 | Reference Example 4 | Reference Example 5 |
|---|---|---|---|---|
| Cured product | Cured product 9 | Reference cured product 4 | Reference cured product 5 | Reference cured product 6 |
| Determination | V-0 | V-1 | V-non-compliant | V-non-compliant |

The determination criteria are as follows.

**[Table 8]**

| Determination criteria | Flammability classification | | | |
|---|---|---|---|---|
| | V-0 | V-1 | V-2 | V-non-compliant |
| Burning time of each test piece | 10 seconds or less | 30 seconds or less | 30 seconds or less | |
| Total burning time of five pieces | 50 seconds or less | 250 seconds or less | 250 seconds or less | Not meeting criteria of V-0 to V-2 |
| Burning + glowing time of each test piece | 30 seconds or less | 60 seconds or less | 60 seconds or less | |
| Burning until clamp | No | No | No | |
| Cotton ignition due to dropped object | No | No | Yes | |

## Claims

1. A resin composition for use in an insulating layer of a printed wiring board, the composition containing polybutadiene
wherein
a molar ratio of a 1,2-bond structure and a 1,4-bond structure in the polybutadiene is 60:40 to 100:0, and
a phosphorus-containing group of formula (III) is bound to one or more carbon atoms in the polybutadiene: 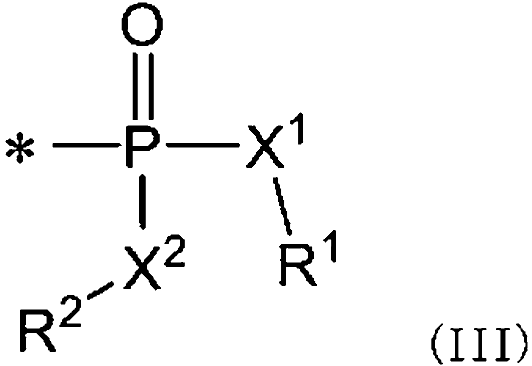 (in formula (III), * represents a binding position, X¹ and X² each independently represent a single bond or an oxygen atom, and R¹ and R² each independently represent an organic group).

2. The resin composition according to claim 1, further containing a polymerization initiator.

3. The resin composition according to claim 1 or 2, wherein the phosphorus-containing group is bound to only a carbon atom at a terminal in the polybutadiene.

4. The resin composition according to claim 1 or 2, wherein a weight average molecular weight of the polybutadiene is 1,000 to 8,000.

5. The resin composition according to claim 1 or 2, wherein a molecular weight distribution of the polybutadiene is 1.00 to 3.00.

6. A prepreg impregnated with the resin composition according to claim 1 or 2.

7. An adhesion film having a resin composition layer on a support film, the resin composition layer containing the resin composition according to claim 1 or 2.

8. A resin composition-attached metal foil having a resin composition layer on a metal foil, the resin composition layer containing the resin composition according to claim 1 or 2.

9. A layered product comprising
a layer of a cured product of the resin composition according to claim 1 or 2, and
a metal foil.

10. A polybutadiene wherein
a molar ratio of a 1,2-bond structure and a 1,4-bond structure in the polybutadiene is 60:40 to 100:0, and
a phosphorus-containing group of formula (III) is bound to only a carbon atom at a terminal in the polybutadiene: 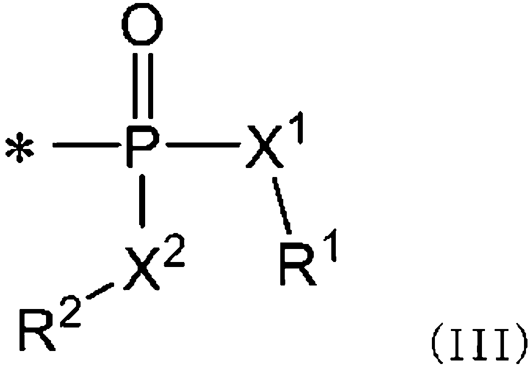 (in formula (III), * represents a binding position, X¹ and X² each independently represent a single bond or an oxygen atom, and R¹ and R² each independently represent an organic group).

11. A method for producing the polybutadiene according to claim 10, the method comprising:
the step of anionically polymerizing 1,3-butadiene in the presence of a solvent and an anionic initiator, and after the anionically polymerizing step,
the step of reacting the resultant with a compound of formula (IV): 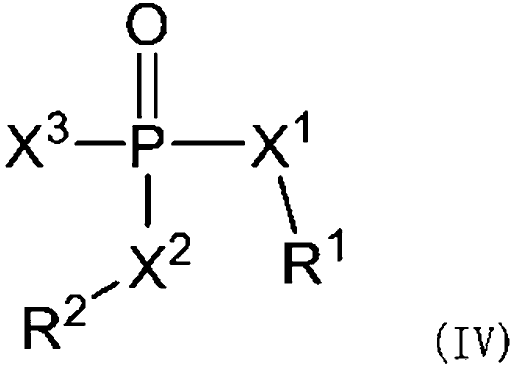 (in formula (IV), X¹, X², R¹ and R² are each defined as in formula (III), X³ represents a halogeno group or a group of formula "-OR³", and R³ represents an organic group).
